(19) **Europäisches Patentamt / European Patent Office / Office européen des brevets**

(11) **EP 2 104 191 A1**

(12) **EUROPEAN PATENT APPLICATION**
published in accordance with Art. 153(4) EPC

(43) Date of publication:
**23.09.2009 Bulletin 2009/39**

(21) Application number: **08801002.0**

(22) Date of filing: **25.09.2008**

(51) Int Cl.:
**H01S 5/0683** (2006.01)  **H01S 5/028** (2006.01)
**H01S 5/323** (2006.01)

(86) International application number:
**PCT/CN2008/072531**

(87) International publication number:
**WO 2009/043292 (09.04.2009 Gazette 2009/15)**

(84) Designated Contracting States:
**AT BE BG CH CY CZ DE DK EE ES FI FR GB GR HR HU IE IS IT LI LT LU LV MC MT NL NO PL PT RO SE SI SK TR**

(30) Priority: **26.09.2007 CN 200710122536**

(71) Applicants:
• **Huawei Technologies Co., Ltd.**
 **Longgang District, Shenzhen**
 **Guangdong 518129 (CN)**
• **Huazhong University of Science and Technology**
 **Wuhan City**
 **Hubei 430074 (CN)**

(72) Inventors:
• **ZHANG, Xinliang**
 **Shenzhen**
 **Guangdong 518129 (CN)**
• **YU, Yu**
 **Shenzhen**
 **Guangdong 518129 (CN)**
• **FU, Wei**
 **Shenzhen**
 **Guangdong 518129 (CN)**

(74) Representative: **Charles, Glyndwr**
 **Reinhard, Skuhra, Weise & Partner GbR**
 **Patent- und Rechtsanwälte**
 **Friedrichstrasse 31**
 **80801 München (DE)**

(54) **SEMICONDUCTOR OPTICAL DEVICE, PROCESS FOR CLOCK RECOVERY AND APPARATUS THEREOF**

(57)    A semiconductor optical device, and a clock recovery method and apparatus are provided. End-face anti-reflective films are set on two end faces of the epitaxial wafer of the semiconductor optical device. The end-face anti-reflective films are configured to perform comb filtering for received optical signals; and its end-face reflectivity is set according to the jitter rate of the amplitude of the clock signal output by the semiconductor optical device. In this way, the quality of the clock signal output by the semiconductor optical device is controlled with a set range. The embodiments of the present invention overcome strict requirements imposed by the prior art on the F parameter of the FP filter. In addition, the clock recovery apparatus is simply structured and easy to use, and can be integrated in a single wafer, thus making the system more integrative.

FIG. 4

EP 2 104 191 A1

**Description**

**Field of the Invention**

The present invention relates to optical networks, and in particular, to a semiconductor optical device as well as a clock recovery method and apparatus.

**Background of the Invention**

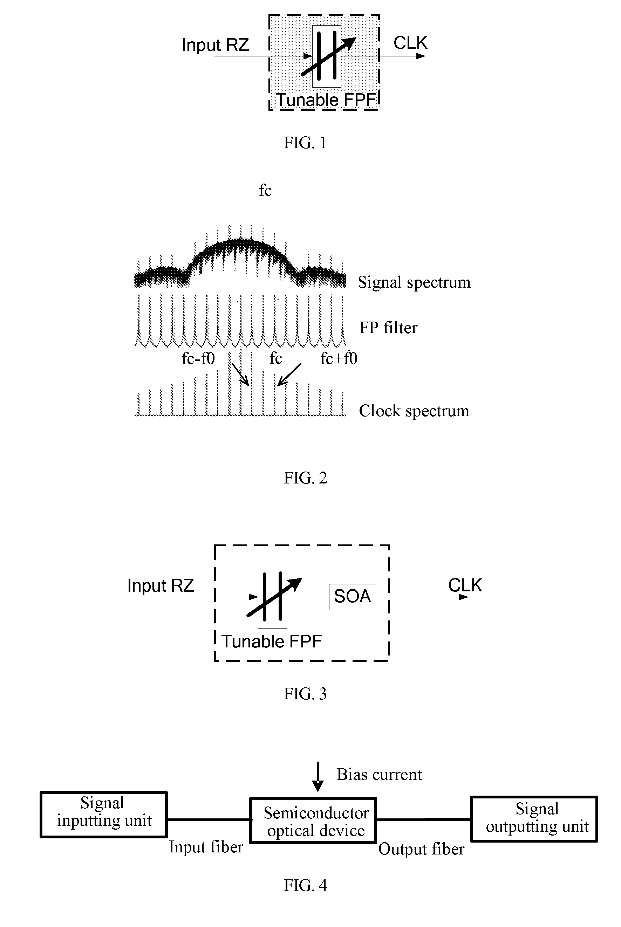

Currently, in a high-speed large-capacity optical network, some factors exert a noticeable impact on the quality of optical signals. For example, the code pattern, line loss, Amplified Spontaneous Emission (ASE) of an optical amplifier, Group Velocity Dispersion (GVD), Polarization Mode Dispersion (PMD), and nonlinear effect affect the shape of signals, optical signal-to-noise ratio, and extinction ratio, spread the pulse and generate timing jitters, and lead to signal degrade.
Regeneration, Reshaping and Retiming (3R) is an effective solution to such problems. All-optical clock recovery in the 3R regeneration is a key technology for implementing optical timing. In a high-speed Optical Time Division Multiplexing (OTDM) system, the fundamental-frequency optical clock recovered from a high-speed OTDM signal is crucial for implementing all-optical demultiplexing and all-optical Add-Drop Multiplexing (ADM). In the optical packet switching, the synchronization between the packet header and the packet also requires fast recovery of the optical clock from the packet header or packet. Therefore, the all-optical clock recovery is a key technology of next-generation high-speed large-capacity optical communication networks.
The key factor for applying the all-optical clock recovery technology to the optical network is to work out a simply structured and practicable solution characterized by short time of setting up clocks, small output jitters, and balanced output amplitudes.
In the prior art, a clock recovery solution is a Fabry-Perot (FP) filter solution. FIG. 1 shows the principles of implementing the FP solution. That is, through an FP filter, the clock signal is recovered from the input Return to Zero (RZ) optical signal. The spectrum of the RZ optical signal is composed of continuous spectral components and several linear components. FIG. 2 shows the comb filter features of an FP filter, where the abscissa represents frequency and the ordinate represents signal amplitude. Through the FP filter, the Frequency Component (FC) and the linear spectrum component "fc+f0" or "fc-f0" (f0 is a data clock frequency) may be selected to recover the optical clock signal.
In the process of researches and applications, the inventor finds at least these defects of the FP filter in the prior art: The solution is limited to the fineness parameter (F parameter) of the FP filter; a very high F parameter value of the FP filter is required; and the Free Spectrum Range (FSR) of the F parameter needs to strictly match the rate of the input signal, thus imposing a very high requirement on the cavity length accuracy of the FP filter. If such requirements are not fulfilled, the recovered clock is degraded drastically. Therefore, the amplitude of the clock recovered according to the foregoing solution in the prior art is uneven.
Another clock recovery solution is provided in the prior art: Improvement is made to the foregoing FP filter solution, and a Semiconductor Optical Amplifier (SOA) is concatenated after the FP filter, as shown in FIG. 3. However, this solution requires the use of two stand-alone devices, and needs to control the input power into the SOA precisely. Consequently, the system is complex and costly, and is hard to be integrated. Moreover, this solution requires strict matching between the FSR of the FP filter and the rate of the input signal, and imposes high requirements on the system.

**Summary of the Invention**

A semiconductor optical device, and a clock recovery method and apparatus are provided in embodiments of the present invention to overcome the low extent of integration in the clock recovery solutions in the prior art and to prevent the limitation to the fineness parameter of the filter.
The objectives of the present invention are achieved through the following technical solution:
A semiconductor optical device includes: a substrate, a buffer layer, an upper restrictive layer, a lower restrictive layer, a cover layer, a contact layer, an upper electrode, and a lower electrode, and further includes: end-face anti-reflective films set on two end faces of an epitaxial wafer, where:

the end-face anti-reflective films are configured to perform comb filtering for the received optical signals; and
the end-face reflectivity of the end-face anti-reflective film is set according to the jitter rate of the amplitude of the clock signal output by the semiconductor optical device.

A clock recovery apparatus includes:

a signal inputting unit, configured to: receive an input optical signal, and output the optical signal to a semiconductor optical device;

the semiconductor optical device, configured to: perform comb filtering for the received optical signal, recover the clock signal from the optical signal, and transmit the clock signal to a signal outputting unit, where the end-face reflectivity of the end-face anti-reflective film on the semiconductor optical device is set according to the jitter rate of the amplitude of the clock signal output by the semiconductor optical device; and

the signal outputting unit, configured to output the clock signal.

A clock recovery method includes:

by a semiconductor optical device, receiving an input optical signal, and performing comb filtering for the optical signal; and

recovering the clock signal from the optical signal, and setting the end-face reflectivity of the end-face anti-reflective film on the semiconductor optical device according to the jitter rate of the amplitude of the clock signal output by the semiconductor optical device.

It can be seen from the technical solution under the present invention that, a proper end-face reflectivity of the semiconductor optical device is selected according to the jitter rate of the amplitude of the clock signal output by the semiconductor optical device, and a low reflectivity and a low fineness are provided. Therefore, mismatch between the FSR of the semiconductor optical device and the rate of the input optical signal is tolerable, and the quality of the recovered clock signal is controlled within the set range, thus overcoming the strict requirements imposed by the prior art on the F parameter of the FP filter. In addition, the clock recovery apparatus under the present invention is simply structured and can be integrated in a single wafer, and therefore, the clock recovery apparatus is highly practicable and the system is more integrative.

**Brief Description of the Drawings**

FIG. 1 shows principles of a clock recovery solution of an FP filter in the prior art;

FIG. 2 shows comb filter features of an FP filter in the clock recovery solution of the FP filter in the prior art;

FIG. 3 shows principles of a clock recovery solution of an improved FP filter in the prior art;

FIG. 4 shows a structure of an all-optical clock recovery apparatus according to a first embodiment of the present invention;

FIG. 5 shows a structure of an epitaxial wafer of a semiconductor optical device according to the first embodiment of the present invention;

FIG. 6 shows a structure of an epitaxial wafer of a semiconductor optical device according to a second embodiment of the present invention;

FIG. 7 shows different output results output by a clock recovery apparatus with different end-face reflectivity values after clock signals are recovered from 80 Gb/s RZ signals according to an embodiment of the present invention;

FIG. 8 shows the relation between the reflectivity of the anti-reflective film of the semiconductor optical device and the jitter rate of the amplitude of the output clock signal according to an embodiment of the present invention; and

FIG. 9 shows a structure of a clock recovery apparatus with a clock enhancing unit according to a third embodiment of the present invention.

**Detailed Description of the Embodiments**

The embodiments of the present invention are detailed below with reference to accompanying drawings. As shown in FIG. 4, the structure of a clock recovery apparatus in the first embodiment of the present invention includes: a signal inputting unit, a semiconductor optical device, and a signal outputting unit.

The signal inputting unit is configured to: receive an input optical signal, and transmit the optical signal to a semiconductor optical device through an input fiber.

The semiconductor optical device is configured to: perform comb filtering for the optical signal, recover a clock signal from the optical signal, and transmit the clock signal to an output fiber.

The signal outputting unit is configured to output the clock signal through the output fiber.

With the end-face reflectivity of the semiconductor optical device being controlled within a specific range, the quality of the output optical clock is controlled within a set best range. Through proper design of the active region length of the semiconductor optical device, the frequency of the recovered clock signal is equal to the frequency interval of the comb filtering. The optical clock quality includes: jitter rate of the amplitude of the clock signal, eye opening extent, or Q factor, or at least one thereof.

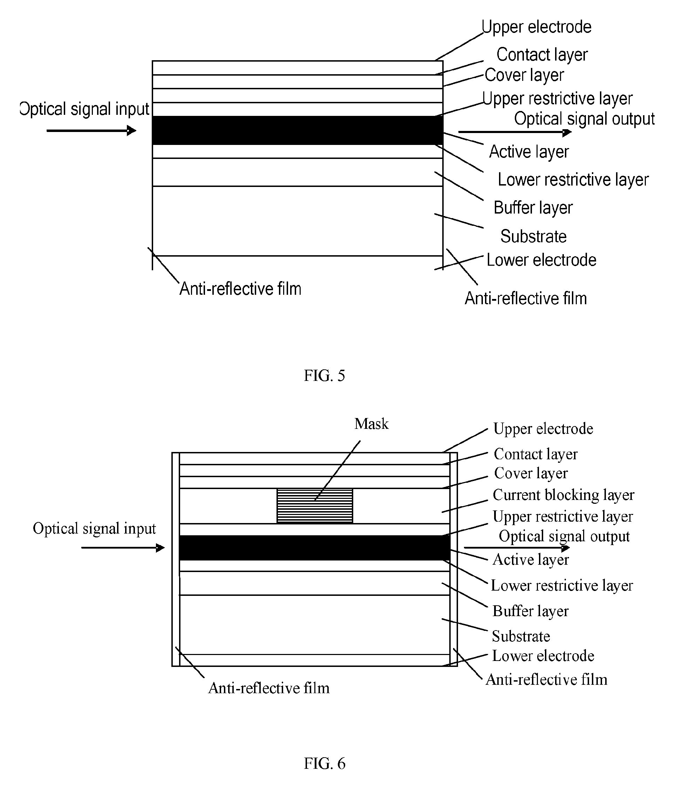

FIG. 5 shows a structure of an epitaxial wafer of a semiconductor optical device according to the first embodiment of the present invention. The structure includes: a substrate, a buffer layer, an upper restrictive layer, a lower restrictive layer, an active layer, a cover layer, a contact layer, an upper electrode, a lower electrode, and an end-face anti-reflective film, as detailed below.

The substrate is made from type-n indium phosphide (n-InP).

The buffer layer is made from n-InP which is 0.5 $\mu$m thick.

The upper restrictive layer and the lower restrictive layer are made from: lattice-matching non-doped indium gallium arseniureted phosphide (InGaAsP), which is 0.1 $\mu$m in thickness and has a central wavelength of 1.2 $\mu$m. The upper restrictive layer and the lower restrictive layer constitute a double heterojunction structure.

The active layer is made from bulk materials or quantum well materials, and introduces different strain modes. The active layer has a refractivity higher than that of the upper restrictive layer and the lower restrictive layer, and serves the purpose of optical waveguide. It restricts the optical signal to be transmitted at the active layer, and fulfills the purpose of conduction. The optical signal passes through the active layer and excites the high-level electrons at the active layer to transit to the low level, and radiates photons, thus amplifying the optical signal power. In the first embodiment, the quantum well InGaAsP of a hybrid strain mode is employed. The strain mode includes 1% compressive strain and 0.95% tensile strain. The active layer is 50 nm thick, and the central wavelength is 1.57 $\mu$m. Through proper design of the active region length, the comb filtering interval is equal to the interval between the modes of input signals, and the frequency of the recovered clock signal is equal to the interval between the modes of input signals. In the first embodiment, supposing the length of the active region is 536 $\mu$m, 80 Gb/s clock signals can be recovered.

The cover layer is made from p-InP which is 1.5 $\mu$m thick.

The contact layer is made from heavy type-p doped InGaAs which is 0.3 $\mu$m thick.

The end-face anti-reflective film is made from silicon oxidized (SiOx), silicon nitride (SixNy), zirconia (ZrOx), titanium dioxide (TiOx), and so on; or is based on the multi-layer film technology. The plated anti-reflective film needs to enable the semiconductor optical device to have the comb filtering function. The end-face reflectivity can be controlled within a certain range through setting of the end-face anti-reflective film material and the thickness of the material. In this way, the quality of the output optical clock is controlled within a set best range.

In the first embodiment, the semiconductor optical device may be made through a Metalorganic Chemical Vapor Deposition (MOCVD) epitaxy technology. The processing flow of the epitaxy technology is: a buffer layer is set on the substrate; a lower restrictive layer is set on the buffer layer; an active layer is set on the lower restrictive layer; an upper restrictive layer is set on the active layer; a cover layer is set on the upper restrictive layer; a contact layer is set on the cover layer; an upper electrode and a lower electrode are evaporated on the epitaxial wafer; the epitaxial wafer is set to a bar shape so that the length of the active region meets the requirements of the clock frequency that needs to be output; and finally, an anti-reflective film is plated on the two end faces of the epitaxial wafer.

Another epitaxial wafer of the semiconductor optical device is provided in the second embodiment of the present invention. As shown in FIG. 6, the epitaxial wafer includes: a substrate, a buffer layer, an upper restrictive layer, a lower restrictive layer, an active layer, a mask, a current blocking layer, a cover layer, a contact layer, an upper electrode, a lower electrode, and an end-face anti-reflective film, as detailed below. The mask and the current blocking layer are added for improving the electron excited emission rate of the active layer. With the improved utilization of the carrier (including electrons and holes) and the restrictive effect on the photons, the carrier is restricted to the active layer more effectively, thus improving the quality of the epitaxial wafer. The modules are described below.

The substrate is made from n-InP.

The buffer layer is made from n-InP which is 0.5 $\mu$m thick.

The upper restrictive layer and the lower restrictive layer are made from: lattice-matching non-doped InGaAsP, which is 0.1 $\mu$m in thickness and has a central wavelength of 1.2 $\mu$m. The upper restrictive layer and the lower restrictive layer constitute a double heterojunction structure.

The active layer is made from bulk materials or quantum well materials, and introduces different strain modes. In the second embodiment, the quantum well InGaAsP of a hybrid strain mode is employed. The strain mode includes 1% compressive strain and 0.95% tensile strain. The active layer is 50 nm thick, and the central wavelength is 1.57 $\mu$m. Through proper design of the active region length, the comb filtering interval is equal to the interval between the modes of input signals, and the frequency of the recovered clock signal is equal to the interval between the modes of input signals. In the second embodiment, supposing the length of the active region is 536 $\mu$m, 80 Gb/s clock signals can be recovered.

The mask is made from SiO2 which is 0.2 $\mu$m thick.

The current blocking layer forms a p-n-p heterojunction active structure through secondary epitaxial setting, thus restricting the carrier to the active layer effectively.

The cover layer is made from p-InP which is 1.5 $\mu$m thick.

The contact layer is made from heavy type-p doped InGaAs which is 0.3 $\mu$m thick.

The end-face anti-reflective film is made from $SiO_x$, $Si_xN_y$, $ZrO_2$, $TiO_x$, and so on; or is based on the multi-layer film technology. The plated anti-reflective film needs to enable the semiconductor optical device to have the comb filtering function. The end-face reflectivity can be controlled within a certain range. In this way, the quality of the output optical clock is controlled within the best range.

In the second embodiment, the semiconductor optical device may be made through an MOCVD epitaxy technology. The processing flow of the epitaxy technology is: a buffer layer is set on the substrate; a lower restrictive layer is set on the buffer layer; an active layer is set on the lower restrictive layer; an upper restrictive layer is set on the active layer; a SiO$_2$ mask is deposited on the upper restrictive layer; a p-n-p current blocking layer is set on two end faces of the mask through the secondary epitaxy technology; a cover layer is set on the current blocking layer through a tertiary epitaxy technology; a contact layer is set on the cover layer; an upper electrode and a lower electrode are evaporated on the epitaxial wafer; the epitaxial wafer is set to a bar shape so that the length of the active region meets the requirements of the clock frequency that needs to be output; finally, an anti-reflective film is plated on the two end faces of the epitaxial wafer. The plated anti-reflective film needs to enable the semiconductor optical device to have the comb filtering function. The end-face reflectivity can be controlled within a certain range. In this way, the quality of the output optical clock is controlled within the best range.

It is necessary to design the active region length and the reflectivity of the anti-reflective film properly so that the foregoing semiconductor optical device can implement the clock recovery function.

The length of the active region of the semiconductor optical device needs to be designed properly. Through proper design of the active region length, the comb filtering interval is equal to the interval between the modes of input signals, and the frequency of the recovered clock signal is equal to the interval frequency between the modes of input signals.

The selection of the active region length L depends on the input signal rate and the effective refractivity of the active region. The active region length L is calculated through formula 1:

$$L = \frac{\lambda^2}{2n \cdot \Delta\lambda} \quad \text{Formula 1}$$

In formula 1, L is the active region length of the resonant cavity; $\lambda$ is the central wavelength of the input signal wave; n is the effective refractivity of the active region of the resonant cavity; and $\Delta\lambda$ is the wavelength interval corresponding to the input signal rate. In practice, therefore, the effective refractivity of the active region of the resonant cavity may be adjusted by adjusting the working current of the clock recovery apparatus. In this way, the active region length L is adjusted.

In this embodiment, when the 80 Gb/s signal is inputted, the input wavelength is 1550 nm; the equivalent refractivity is 3.5; $\Delta\lambda$ is 0.64 nm; the corresponding comb filter interval frequency is 80 GHz; and therefore, the active region length of the resonant cavity is approximately 536 $\mu$m, and 80 GHz clock signals can be recovered.

In practice, the bias current received by the foregoing clock recovery apparatus needs to be biased properly, and the average power of the input signal needs to reach a certain value, thus ensuring the foregoing clock recovery apparatus to work in the gain-saturated state. In this embodiment, the bias current is 250 mA, and the average power of the input signal is 3 mW.

The design of the reflectivity of the anti-reflective film is vital to the implementation of the foregoing clock recovery apparatus. Generally, the Fresnel reflectivity of the cleavage plane of the active region is about 30%. Therefore, an anti-reflective film needs to be plated on the cleavage plane to reduce the reflectivity. By designing the reflectivity R1 and R2 of the anti-reflective film, the clock recovery apparatus is capable of filtering out multiple modes of the input signal through the comb filtering function.

The reflectivity of the anti-reflective film of an ordinary SOA is $10^{-6}$. In this embodiment, the reflectivity of the anti-reflective film is assumed to be 0.1. Therefore, the reflectivity of the anti-reflective film in this embodiment is much higher than that of the ordinary SOA; the plating process is much simpler; and the making of the semiconductor optical device is much simpler than that of the ordinary SOA.

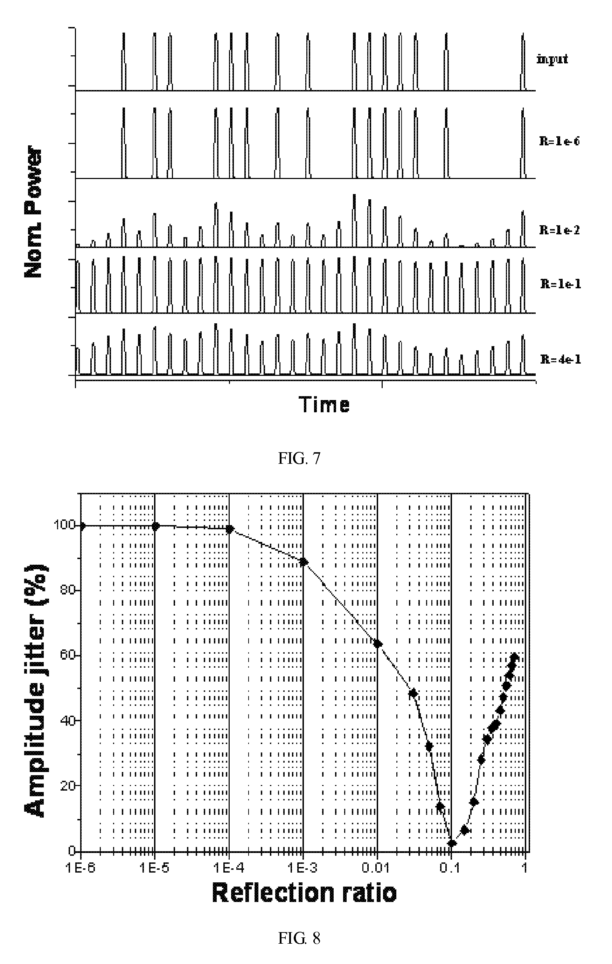

FIG. 7 shows different output results output by a clock recovery apparatus with different end-face reflectivity values after clock signals are recovered from 80 Gb/s RZ signals. In FIG. 7, the abscissa represents time, and the ordinate represents the amplitude of the output clock signal. From the top to the down, FIG. 7 illustrates the waveform of the input signal and clock signals output by four clock recovery apparatuses with different end-face reflectivity values. The four clock recovery apparatuses correspond to these reflectivity values: $10^{-6}$, $10^{-2}$, $10^{-1}$, and 0.4, respectively.

As shown in FIG. 7, the reflectivity $10^{-6}$ brings the effect of amplification; that is, the amplification function of the SOA is implemented; and the reflectivity $10^{-1}$ makes the clock amplitude jitter rate smallest, and leads to the best quality of the output clock signal. FIG. 8 shows the relation between the reflectivity of the anti-reflective film and the amplitude jitter rate of the output clock signal. In FIG. 8, the abscissa represents the reflectivity of the anti-reflective film;

the ordinate represents the amplitude jitter rate of the output clock signal; and the minimum jitter rate indicates the most balanced pulse amplitude of the output clock signal and the best quality of the output clock signal. Therefore, the end-face reflectivity needs to be appropriate, and needs to be designed optimally according to the actual conditions.

In the actual application, the optimal end-face reflectivity needs to be worked out according to the amplitude jitter rate of the clock signal output by the clock recovery apparatus. The amplitude jitter rate is defined as the ratio of a difference to a sum, namely, the difference between the maximum peak power and the minimum peak power of the output optical clock signal, to the sum of the maximum peak power and the minimum peak power of the output optical clock signal.

The gain spectrum of the clock recovery apparatus is calculated through formula 2:

$$G = \frac{(1-R_1)(1-R_2)G_s}{1+R_1 \cdot R_2 \cdot G_s^2 - 2\sqrt{R_1 R_2} \cdot G_s \cdot \cos\theta} \quad \text{Formula 2}$$

In formula 2, R1 is the reflectivity of the front end face of the resonant cavity and R2 is the reflectivity of the rear end face of the resonant cavity; R1 = R2; Gs is the single-pass gain (namely, the ordinary SOA gain under the same parameters); and θ is the single-pass phase change. The single-pass gain Gs depends on the power of the input signal, the length of the active region of the amplifier, and the injected current, and can be calculated out through formula 3 and formula 4:

$$0 = \frac{I}{qV} - \frac{N}{\tau_c} - \frac{\Gamma g_N (N - N_T) P_{avg}}{Ahc/\lambda} \quad \text{Formula 3}$$

$$G_s = \exp[(\Gamma g_N (N - N_T) - \alpha_{\text{int}}) L_{SOA}] \quad \text{Formula 4}$$

In formula 3 and formula 4, the carrier concentration N and the single-pass gain Gs are unknown numbers to be calculated, and others are parameters or working conditions of the amplifier: I is the bias current; q is the basic charge; $\tau_c$ is the carrier recovery time; $\Gamma$ is a mode field limiting factor; $g_N$ is a differential gain coefficient; $N_T$ is the transparent carrier concentration; V is the volume of the active region; A is the area of the cross-section of the active region; $hc/\lambda$ is the photon energy corresponding to the specific wavelength; Pavg is the average optical power of the input signals; and $\alpha_{\text{int}}$ is an internal loss coefficient of the active region.

The optimal end-face reflectivity may be worked out through value emulation or experiment. The calculation method for working out the optimal end-face reflectivity through value emulation in this embodiment is as follows:

First, the spectrum of the input signal is calculated out through the Fourier transformation method; the calculated spectrum is multiplied by the gain spectrum of the clock recovery apparatus; and the spectrum of the output signal is obtained. Anti-Fourier transformation is performed for the spectrum of the output signal to obtain a time-domain optical signal, namely, to obtain the output optical signal. Then the amplitude jitter rate of the optical clock signal is calculated out.

Afterward, the end-face reflectivity changes continuously to acquire different gain spectrums, thus obtaining different amplitude jitter rates. The end-face reflectivity corresponding to the minimum amplitude jitter rate is worked out, and this end-face reflectivity is the optimal end-face reflectivity.

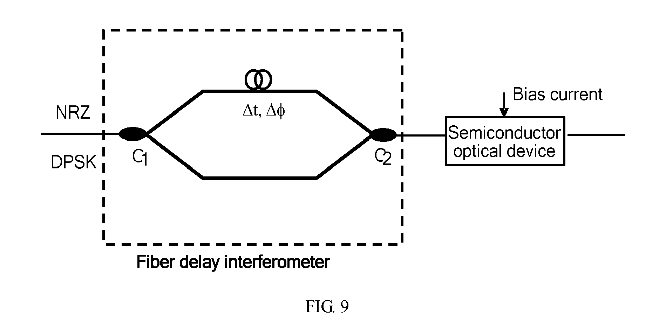

Another clock recovery apparatus is provided in the third embodiment of the present invention. This clock recovery apparatus further includes a clock enhancing unit. FIG. 9 shows a structure of a clock recovery apparatus with a clock enhancing unit in the third embodiment of the present invention. The clock enhancing unit in FIG. 9 is a fiber delay interferometer. After the input signals such as NRZ and DPSK signals pass through the fiber delay interferometer, the clock component is amplified. The input signals further pass through the foregoing clock recovery apparatus to recover the clock signals.

The clock enhancing unit may be a combination of the polarization-maintaining fiber environment, SOA and fiber Bragg grating.

The fineness parameter depends on the end-face reflectivity of the FP filter. Because the end-face reflectivity of the FP filter is very high (above 70%), the fineness is high. High fineness is vulnerable to optical signal wavelength disturbance, which leads to a high amplitude jitter rate of the recovered optical clock signal. The semiconductor optical device disclosed herein sets the end-face reflectivity according to the quality of the recovered clock signal, and provides a low reflectivity (such as 10%) and low fineness, thus leading to the best quality of the recovered clock signal.

The FP filter provides a high reflectivity, and the filtering bandwidth of the filter for a single wavelength is small. If the FSR of the filter does not match the input optical signal rate, namely, if the clock component of the input optical signal falls outside the filtering bandwidth, no optical clock signal can be recovered, or the recovered optical clock signal is of low quality.

The semiconductor optical device under the present invention sets the end-face reflectivity according to the quality of the recovered clock signal. The reflectivity is relatively lower; the filtering bandwidth is relatively higher; and therefore, mismatch between the FSR of the semiconductor optical device and the rate of the input optical signal is more tolerable.

It is understandable to those skilled in the art that all or part of the steps in the clock recovery method may be performed through hardware instructed by a program. The program may be stored in a computer-readable storage medium such as a read-only memory, a magnetic disk, and a compact disk.

To sum up, through proper selection of the active region length and the end-face reflectivity of the semiconductor optical device in the foregoing clock recovery apparatus, the all-optical clock recovery of different rates is implemented, and the quality of the clock signal is controlled within the best range, thus overcoming the strict requirement imposed by the prior art on the F parameter of the FP filter. In addition, the clock recovery apparatus is simply structured and easy to use, and can be integrated in a single wafer. Therefore, the system is more integrative and highly practical.

Although the invention has been described through some exemplary embodiments, the invention is not limited to such embodiments. It is apparent that those skilled in the art can make various modifications and variations to the invention without departing from the spirit and scope of the invention. The invention is intended to cover the modifications and variations provided that they fall in the scope of protection defined by the following claims or their equivalents.

**Claims**

1. A semiconductor optical device, comprising: a substrate, a buffer layer, an upper restrictive layer, a lower restrictive layer, a cover layer, a contact layer, an upper electrode, and a lower electrode, wherein the semiconductor optical device further comprises:

   end-face anti-reflective films set on two end faces of an epitaxial wafer, wherein:
   the end-face anti-reflective films are configured to perform comb filtering for received optical signals; and end-face reflectivity of the end-face anti-reflective films is set according to a jitter rate of an amplitude of a clock signal output by the semiconductor optical device.

2. The semiconductor optical device of claim 1, wherein the setting of the end-face reflectivity of the end-face reflective films according to the amplitude jitter rate of the clock signal output by the semiconductor optical device comprises:

   setting the end-face reflectivity of the end-face anti-reflective films within a set range according to a result of comparison between different amplitude jitter rates of different clock signals output by the semiconductor optical device.

3. The semiconductor optical device of claim 1 or 2, further comprising: an active layer set between the lower restrictive layer and the upper restrictive layer, wherein:

   the active layer is configured to transmit and amplify the optical signal received by the semiconductor optical device; and the length of the active layer is set according to effective refractivity of the active layer.

4. The semiconductor optical device of claim 3, further comprising:

   a mask and a current blocking layer, wherein: the mask is set on the upper restrictive layer, and the current blocking layer is set on two end faces of the mask.

5. A clock recovery apparatus, comprising:

   a signal inputting unit, configured to: receive an input optical signal, and output the optical signal to a semiconductor optical device;
   the semiconductor optical device, configured to: perform comb filtering for the received optical signal, recover a clock signal from the optical signal, and transmit the clock signal to a signal outputting unit, wherein end-face reflectivity of an end-face anti-reflective film on the semiconductor optical device is set according to a jitter rate of an amplitude of the clock signal output by the semiconductor optical device; and
the signal outputting unit, configured to output the clock signal.

6. The apparatus of claim 5, wherein:

the semiconductor optical device is further configured to transmit and amplify the received optical signal in an active layer of the semiconductor optical device; and the length of the active layer is set according to the effective refractivity of the active layer.

7. A clock recovery method, comprising:

by a semiconductor optical device, receiving an input optical signal, and performing comb filtering for the optical signal; and
recovering a clock signal from the optical signal, and setting end-face reflectivity of an end-face anti-reflective film on the semiconductor optical device according to a jitter rate of an amplitude of the clock signal output by the semiconductor optical device.

8. The method of claim 7, further comprising:

by the semiconductor optical device, transmitting and amplifying the received optical signal in an active layer of the semiconductor optical device, and setting the length of the active layer of the semiconductor optical device according to effective refractivity of the active layer.

9. The method of claim 7 or 8, further comprising:

setting the end-face reflectivity of the end-face anti-reflective film of the semiconductor optical device within a set range according to a result of comparison between different amplitude jitter rates of different clock signals output by the semiconductor optical device.

10. The method of claim 7 or 8, further comprising:

setting the effective refractivity of the active layer by setting working current of the semiconductor optical device.

Input RZ ————→| Tunable FPF |————→ CLK

FIG. 1

fc

Signal spectrum

FP filter

fc-f0    fc    fc+f0

Clock spectrum

FIG. 2

Input RZ ————→ | Tunable FPF | —→ | SOA | ————→ CLK

FIG. 3

↓ Bias current

| Signal inputting unit | Input fiber | Semiconductor optical device | Output fiber | Signal outputting unit |

FIG. 4

Upper electrode

Contact layer

Cover layer

Upper restrictive layer

Optical signal input

Optical signal output

Active layer

Lower restrictive layer

Buffer layer

Substrate

Lower electrode

Anti-reflective film

Anti-reflective film

FIG. 5

Mask

Upper electrode

Contact layer

Cover layer

Current blocking layer

Upper restrictive layer

Optical signal input

Optical signal output

Active layer

Lower restrictive layer

Buffer layer

Substrate

Lower electrode

Anti-reflective film

Anti-reflective film

FIG. 6

FIG. 7

FIG. 8

FIG. 9

# INTERNATIONAL SEARCH REPORT

International application No.

PCT/CN2008/072531

### A. CLASSIFICATION OF SUBJECT MATTER

See extra sheet

According to International Patent Classification (IPC) or to both national classification and IPC

### B. FIELDS SEARCHED

Minimum documentation searched (classification system followed by classification symbols)

IPC:H01S5/-

Documentation searched other than minimum documentation to the extent that such documents are included in the fields searched

Electronic data base consulted during the international search (name of data base and, where practicable, search terms used)

WPI, EPODOC, PAJ, CNKI, CPRS, IEE; Keywords: antireflection, reflectance, +reflect+, jitter, ripple, clock recovery, clock reproduction, filter, semiconduct+, active layer

### C. DOCUMENTS CONSIDERED TO BE RELEVANT

| Category | Citation of document, with indication, where appropriate, of the relevant passages | Relevant to claim No. |
|---|---|---|
| A | Hisakazu Kurita et. al. , "Ultrafast all-optical signal processing with mode-locked semiconductor lasers" IEICE Transactions on electronics, 28 Feb. 1998(28.02.1998), vol. E81-C, N0. 2, Pages 129-138 | 1-10 |
| A | CN 1271193 A (CANON K K) 25 October 2000(25.10.2000), last three paragraphs of Page8, Figure 5 | 1-4 |
| A | CN 1533005 A (FUJI XEROX CO LTD) 29. September 2004(29.09.2004) Page 8, line 25--Page 9,line 5; Fig 1 | 4 |

☒ Further documents are listed in the continuation of Box C.     ☒ See patent family annex.

| | |
|---|---|
| * Special categories of cited documents: | "T" later document published after the international filing date or priority date and not in conflict with the application but cited to understand the principle or theory underlying the invention |
| "A" document defining the general state of the art which is not considered to be of particular relevance | |
| "E" earlier application or patent but published on or after the international filing date | "X" document of particular relevance; the claimed invention cannot be considered novel or cannot be considered to involve an inventive step when the document is taken alone |
| "L" document which may throw doubts on priority claim (S) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | |
| "P" document published prior to the international filing date but later than the priority date claimed | "&"document member of the same patent family |

| Date of the actual completion of the international search | Date of mailing of the international search report |
|---|---|
| 28 November 2008(28.11.2008) | **11 Dec. 2008 (11.12.2008)** |

| Name and mailing address of the ISA/CN | Authorized officer |
|---|---|
| The State Intellectual Property Office, the P.R.China<br>6 Xitucheng Rd., Jimen Bridge, Haidian District, Beijing, China<br>100088<br>Facsimile No. 86-10-62019451 | **HAN, Bing**<br>Telephone No. (86-10)62414371 |

Form PCT/ISA/210 (second sheet) (April 2007)

| INTERNATIONAL SEARCH REPORT | International application No. |
| --- | --- |
| | PCT/CN2008/072531 |

C (Continuation). DOCUMENTS CONSIDERED TO BE RELEVANT

| Category* | Citation of document, with indication, where appropriate, of the relevant passages | Relevant to claim No. |
| --- | --- | --- |
| A | JP 2007-42737 A (MITSUBISHI ELECTRIC CORP) 15. February 2007(15. 02.2007) paragraphs 16-41; Figure 2 | 1-10 |
| A | CN 1607412 A (SAMSUNG ELECTRONICS CO LTD) 20 April 2005(20.04.2005) Page 1, line 26-30; page 2, line 1-4, 16-28; Figures 1, 3 | 1-10 |
| A | US 5790302 A(LUKAS F. TIEMEIJER et. al.) 04 August 1998(04.08.1998)   Full text | 1-10 |
| A | US 2004/0125845 A1 (KYUNG-HYUN PARK et. al.) 01 July 2004(01.07.2004) Full Text | 1-10 |

Form PCT/ISA/210 (continuation of second sheet ) (April 2007)

## INTERNATIONAL SEARCH REPORT
Information on patent family members

International application No.

PCT/CN2008/072531

| Patent Documents referred in the Report | Publication Date | Patent Family | | Publication Date |
|---|---|---|---|---|
| CN1271193A | 25.10.2000 | KR20010014765 | A | 26.02.2001 |
| | | JP2001111160 | A | 20.04.2001 |
| | | US6566155 | B1 | 20.05.2003 |
| CN1533005A | 29.09.2004 | US2004184500 | A1 | 23.09.2004 |
| | | US7251262 | B | 31.07.2007 |
| | | JP2004288674 | A | 14.10.2004 |
| | | US2006120426 | A1 | 08.06.2006 |
| | | US7352782 | B2 | 01.04.2008 |
| JP 2007-42737 A | 15. 02.2007 | None | | |
| CN1607412A | 20.04.2005 | US2005078359 | A1 | 14.04.2005 |
| | | US7173757 | B2 | 06.02.2007 |
| | | KR20050035580 | A | 19.04.2005 |
| | | JP2005123612 | A | 12.05.2005 |
| US5790302A | 04.08.1998 | WO9619023 | A2 | 20.06.1996 |
| | | EP0744090 | A1 | 27.11.1996 |
| | | JP9509535 | T | 22.09.1997 |
| | | US5790302 | A | 04.08.1998 |
| | | DE69510331 | T2 | 25.11.1999 |
| US2004/0125845A1 | 01.07.2004 | KR20040051905 | A | 19.06.2004 |
| | | US7012945 | B2 | 14.03.2006 |

Form PCT/ISA/210 (patent family annex) (April 2007)

**INTERNATIONAL SEARCH REPORT**

| International application No. |
| --- |
| PCT/CN2008/072531 |

Continuation of : second sheet , A. CLASSIFICATION OF SUBJECT MATTER

H01S 5/0683 (2006.01) i

H01S 5/028 (2006.01) i

H01S 5/323 (2006.01) i

Form PCT/ISA/210 (extra sheet) (April 2007)